# EUROPEAN PATENT APPLICATION

(11) **EP 3 758 081 A1**
(43) Date of publication of application: **30.12.2020**
(21) Application number: 20166163.4
(22) Date of filing: 27.03.2020
(51) Int. Cl.: H01L 49/02, H01L 21/768, H01L 27/108

(54) **AIR GAPS AND CAPACITORS IN DIELECTRIC LAYERS**

(30) Priority: 28.06.2019 US 201916457648
(71) Applicant: Intel Corporation, Santa Clara, CA 95054 (US)
(72) Inventor: LAJOIE, Travis W., Forest Grove, OR 97116 (US); SHARMA, Abhishek, Hillsboro, OR 97124 (US); LE, Van H., Beaverton, OR 97007 (US); KU, Chieh-Jen, Hillsboro, OR 97124 (US); WANG, Pei-Hua, Beaverton, OR 97006 (US); KAVALIEROS, Jack, Portland, OR 97229 (US); SELL, Bernhard, Portland, OR 97229 (US); GHANI, Tahir, Portland, OR 97229 (US); GEORGE, Gregory, Beaverton, OR 97007 (US); GARG, Akash, Portland, OR 97209 (US); GARDINER, Allen B., Portland, OR 97229 (US); OGADHOH, Shem, West Linn, OR 97068 (US); ALZATE VINASCO, Juan G., Tigard, OR 97223 (US); ARSLAN, Umut, Portland, OR 97229 (US); HAMZAOGLU, Fatih, Portland, OR 97229 (US); MEHTA, Nikhil, Portland, OR 97229 (US); HUANG, Yu-Wen, Beaverton, OR 97078 (US); ZHOU, Shu, Portland, OR 97229 (US)
(74) Representative: HGF

(57) **Abstract**

Embodiments herein describe techniques for a semiconductor device including a substrate, a first inter-level dielectric (ILD) layer above the substrate, and a second ILD layer above the first ILD layer. The semiconductor device further includes a capacitor having a bottom plate above the substrate, a capacitor dielectric layer adjacent to and above the bottom plate, and a top plate adjacent to and above the capacitor dielectric layer. The bottom plate, the capacitor dielectric layer, and the top plate are within the first ILD layer or the second ILD layer. Furthermore, an air gap is formed next to the top plate and below a top surface of the second ILD layer. Other embodiments may be described and/or claimed.

## Description

### FIELD

Embodiments of the present disclosure generally relate to the field of semiconductor devices, and more particularly, to capacitors in dielectric layers at the back-end-of-line of semiconductor processing.

### BACKGROUND

Capacitors may be used in memory devices, which are important parts of integrated circuits (IC) and semiconductor devices. A memory device, e.g., a dynamic random access memory (DRAM) array, may include a plurality of memory cells, where a memory cell may include a selector, e.g., a transistor, to control the access to a storage cell, e.g., a capacitor. A silicon transistor in a substrate or a thin-film transistor (TFT) in the back-end-of-line of semiconductor processing may be used as a selector for a memory device. However, current designs and implementations of memory devices, e.g., DRAM devices, still face many challenges. In addition to memory devices, capacitors may be used in many other applications.

### BRIEF DESCRIPTION OF THE DRAWINGS

Embodiments will be readily understood by the following detailed description in conjunction with the accompanying drawings. To facilitate this description, like reference numerals designate like structural elements. Embodiments are illustrated by way of example and not by way of limitation in the figures of the accompanying drawings.
**Figures 1(a)-1(c)** schematically illustrate diagrams of a semiconductor device including a capacitor and an air gap formed in dielectric layers, in accordance with some embodiments.
**Figure 2** schematically illustrates a diagram of a memory cell including an air gap next to a capacitor coupled to a thin-film-transistor (TFT) in BEOL, in accordance with some embodiments.
**Figure 3** illustrates a process for forming a semiconductor device including a capacitor and an air gap in dielectric layers, in accordance with some embodiments.
**Figure 4** schematically illustrates a memory array with multiple memory cells including a transistor and a capacitor, in accordance with some embodiments.
**Figure 5** schematically illustrates an interposer implementing one or more embodiments of the disclosure, in accordance with some embodiments.
**Figure 6** schematically illustrates a computing device built in accordance with an embodiment of the disclosure, in accordance with some embodiments.

### DETAILED DESCRIPTION

Memory devices are important parts of integrated circuits (IC) and semiconductor devices. High density or high bandwidth memory devices may be particularly useful for many applications, e.g., graphics, artificial intelligence, machine learning, or compute in or near memory. Dynamic random access memory (DRAM), or an enhanced or embedded dynamic random access memory (eDRAM), may be one of the leading candidates for high density or high bandwidth memory devices. A memory array, e.g., a DRAM or an eDRAM, may include a plurality of memory cells, wherein a memory cell may include a selector, e.g., a transistor, to control the access to a storage cell. In embodiments, the storage cell may be a capacitor to store charge, resulting in a 1T1C (one transistor, one capacitor) architecture for the memory cell.

Memory devices may be implemented with capacitor over bit (COB). However, conventional implementations of memory devices, e.g., 1T1C device, may face some problems. For example, a plate of a capacitor in a memory cell may have a flat surface fully filled by conductive materials. Such a capacitor may occupy considerable area due to spatial or volume requirements of the capacitors, while the semiconductor process for making such a capacitor may have a low yield.

Embodiments herein may present a semiconductor device including a capacitor and an air gap next to a plate of the capacitor. For example, a top plate of the capacitor may include a U-shaped portion, and a void space may be formed by the U-shape portion of the top plate. Instead of completely filling the void space formed by the U-shaped portion to form a flat top plate for the capacitor, an air gap may be formed within the void space formed by the U-shape portion of the top plate. Hence, embodiments herein may reduce the conductive material used to fill the top plate. As a result, the semiconductor process for making such a capacitor may have improved yield. Capacitors presented in embodiments herein may be used in memory cells or many other applications.

Embodiments herein may present a semiconductor device including a substrate. A first inter-level dielectric (ILD) layer is formed above the substrate, and a second ILD layer is formed above the first ILD layer. The semiconductor device further includes a capacitor having a bottom plate above the substrate, a capacitor dielectric layer adjacent to and above the bottom plate, and a top plate adjacent to and above the capacitor dielectric layer. The bottom plate, the capacitor dielectric layer, and the top plate are within the first ILD layer or the second ILD layer. Furthermore, an air gap is formed next to the top plate and below a top surface of the second ILD layer.

Embodiments herein may present a method for forming a semiconductor device. The method includes forming a first ILD layer above a substrate. Furthermore, the method includes: forming a bottom plate of a capacitor within the first ILD layer, forming a capacitor dielectric layer adjacent to and above the bottom plate, and forming a top plate of the capacitor adjacent to and above the capacitor dielectric layer. The method further includes forming a hard mask layer covering an area of the top plate, and forming a second ILD layer to cover the hard mask layer and the top plate of the capacitor. Afterward, the method includes removing the hard mask layer below the second ILD layer and above the area of the top plate to form an air gap surrounded by the second ILD layer and the top plate.

Embodiments herein may present a computing device, which may include a circuit board, and a memory device coupled to the circuit board and including a memory array. In more detail, the memory array may include a plurality of memory cells. A memory cell of the plurality of memory cells includes a transistor and a capacitor. The transistor includes a gate electrode above a substrate, and a channel layer including a channel material and separated from the gate electrode by a gate dielectric layer. The transistor further includes a source electrode and a drain electrode above the channel layer. The capacitor includes a bottom plate above the substrate, a capacitor dielectric layer adjacent to and above the bottom plate, and a top plate adjacent to and above the capacitor dielectric layer. The bottom plate, the capacitor dielectric layer, and the top plate of the capacitor are within a first ILD layer or a second ILD layer above the first ILD layer. The drain electrode of the transistor is coupled to the bottom plate of the capacitor. The top plate of the capacitor is coupled to a source line of the memory array, and the gate electrode of the transistor is coupled to a word line of the memory array. The semiconductor device further includes an air gap next to the top plate and below a top surface of the second ILD layer.

Front-end-of-line (FEOL) semiconductor processing and structures may refer to a first portion of IC fabrication where individual devices (e.g., transistors, capacitors, resistors, etc.) are patterned in a semiconductor substrate or layer. FEOL generally covers everything up to (but not including) the deposition of metal interconnect layers. A transistor formed in FEOL may also be referred to as a front-end transistor. Following the last FEOL operation, the result is typically a wafer with isolated transistors (e.g., without any wires). Back end of line (BEOL) semiconductor processing and structures may refer to a second portion of IC fabrication where the individual devices (e.g., transistors, capacitors, resistors, etc.) are interconnected with wiring on the wafer, e.g., the metallization layer or layers. BEOL includes metal contacts, dielectrics layers, metal levels, and bonding sites for chip-to-package connections. In the BEOL part of the fabrication, metal contacts, pads, interconnect wires, vias, and dielectric structures may be formed. For modern IC processes, more than 10 metal layers may be added in the BEOL. A thin film transistor (TFT) is a kind of field-effect transistor formed at BEOL and including a channel layer, a gate electrode, and source and drain electrodes, over a supporting but non-conducting substrate.

In the following description, various aspects of the illustrative implementations will be described using terms commonly employed by those skilled in the art to convey the substance of their work to others skilled in the art. However, it will be apparent to those skilled in the art that the present disclosure may be practiced with only some of the described aspects. For purposes of explanation, specific numbers, materials and configurations are set forth in order to provide a thorough understanding of the illustrative implementations. However, it will be apparent to one skilled in the art that the present disclosure may be practiced without the specific details. In other instances, well-known features are omitted or simplified in order not to obscure the illustrative implementations.

Various operations will be described as multiple discrete operations, in turn, in a manner that is most helpful in understanding the present disclosure. However, the order of description should not be construed to imply that these operations are necessarily order dependent. In particular, these operations may not be performed in the order of presentation. For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B and C).

The terms "over," "under," "between," "above," and "on" as used herein may refer to a relative position of one material layer or component with respect to other layers or components. For example, one layer disposed over or under another layer may be directly in contact with the other layer or may have one or more intervening layers. Moreover, one layer disposed between two layers may be directly in contact with the two layers or may have one or more intervening layers. In contrast, a first layer "on" a second layer is in direct contact with that second layer. Similarly, unless explicitly stated otherwise, one feature disposed between two features may be in direct contact with the adjacent features or may have one or more intervening features.

The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

The term "coupled with," along with its derivatives, may be used herein. "Coupled" may mean one or more of the following. "Coupled" may mean that two or more elements are in direct physical or electrical contact. However, "coupled" may also mean that two or more elements indirectly contact each other, but yet still cooperate or interact with each other, and may mean that one or more other elements are coupled or connected between the elements that are said to be coupled with each other. The term "directly coupled" may mean that two or more elements are in direct contact.

In various embodiments, the phrase "a first feature formed, deposited, or otherwise disposed on a second feature" may mean that the first feature is formed, deposited, or disposed over the second feature, and at least a part of the first feature may be in direct contact (e.g., direct physical and/or electrical contact) or indirect contact (e.g., having one or more other features between the first feature and the second feature) with at least a part of the second feature.

Where the disclosure recites "a" or "a first" element or the equivalent thereof, such disclosure includes one or more such elements, neither requiring nor excluding two or more such elements. Further, ordinal indicators (e.g., first, second, or third) for identified elements are used to distinguish between the elements, and do not indicate or imply a required or limited number of such elements, nor do they indicate a particular position or order of such elements unless otherwise specifically stated.

As used herein, the term "circuitry" may refer to, be part of, or include an Application Specific Integrated Circuit (ASIC), an electronic circuit, a processor (shared, dedicated, or group), and/or memory (shared, dedicated, or group) that execute one or more software or firmware programs, a combinational logic circuit, and/or other suitable hardware components that provide the described functionality. As used herein, "computer-implemented method" may refer to any method executed by one or more processors, a computer system having one or more processors, a mobile device such as a smartphone (which may include one or more processors), a tablet, a laptop computer, a set-top box, a gaming console, and so forth.

Implementations of the disclosure may be formed or carried out on a substrate, such as a semiconductor substrate. In one implementation, the semiconductor substrate may be a crystalline substrate formed using a bulk silicon or a silicon-on-insulator substructure. In other implementations, the semiconductor substrate may be formed using alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-V or group IV materials. Although a few examples of materials from which the substrate may be formed are described here, any material that may serve as a foundation upon which a semiconductor device may be built falls within the spirit and scope of the present disclosure.

A plurality of transistors, such as metal-oxide-semiconductor field-effect transistors (MOSFET or simply MOS transistors), may be fabricated on the substrate. In various implementations of the disclosure, the MOS transistors may be planar transistors, nonplanar transistors, or a combination of both. Nonplanar transistors include FinFET transistors such as double-gate transistors and tri-gate transistors, and wrap-around or all-around gate transistors such as nanoribbon and nanowire transistors. Although the implementations described herein may illustrate only planar transistors, it should be noted that the disclosure may also be carried out using nonplanar transistors.

Each MOS transistor includes a gate stack formed of at least two layers, a gate dielectric layer and a gate electrode layer. The gate dielectric layer may include one layer or a stack of layers. The one or more layers may include silicon oxide, silicon dioxide (SiO₂) and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric layer include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric layer to improve its quality when a high-k material is used.

The gate electrode layer is formed on the gate dielectric layer and may consist of at least one P-type work function metal or N-type work function metal, depending on whether the transistor is to be a PMOS or an NMOS transistor. In some implementations, the gate electrode layer may consist of a stack of two or more metal layers, where one or more metal layers are work function metal layers and at least one metal layer is a fill metal layer. Further metal layers may be included for other purposes, such as a barrier layer.

For a PMOS transistor, metals that may be used for the gate electrode include, but are not limited to, ruthenium, palladium, platinum, cobalt, nickel, and conductive metal oxides, e.g., ruthenium oxide. A P-type metal layer will enable the formation of a PMOS gate electrode with a work function that is between about 4.9 eV and about 5.2 eV. For an NMOS transistor, metals that may be used for the gate electrode include, but are not limited to, hafnium, zirconium, titanium, tantalum, aluminum, alloys of these metals, and carbides of these metals such as hafnium carbide, zirconium carbide, titanium carbide, tantalum carbide, and aluminum carbide. An N-type metal layer will enable the formation of an NMOS gate electrode with a work function that is between about 3.9 eV and about 4.2 eV.

In some implementations, when viewed as a cross-section of the transistor along the source-channel-drain direction, the gate electrode may consist of a "U"-shaped structure that includes a bottom portion substantially parallel to the surface of the substrate and two sidewall portions that are substantially perpendicular to the top surface of the substrate. In another implementation, at least one of the metal layers that form the gate electrode may simply be a planar layer that is substantially parallel to the top surface of the substrate and does not include sidewall portions substantially perpendicular to the top surface of the substrate. In further implementations of the disclosure, the gate electrode may consist of a combination of U-shaped structures and planar, non-U-shaped structures. For example, the gate electrode may consist of one or more U-shaped metal layers formed atop one or more planar, non-U-shaped layers.

In some implementations of the disclosure, a pair of sidewall spacers may be formed on opposing sides of the gate stack that bracket the gate stack. The sidewall spacers may be formed from a material such as silicon nitride, silicon oxide, silicon carbide, silicon nitride doped with carbon, and silicon oxynitride. Processes for forming sidewall spacers are well known in the art and generally include deposition and etching process operations. In an alternate implementation, a plurality of spacer pairs may be used, for instance, two pairs, three pairs, or four pairs of sidewall spacers may be formed on opposing sides of the gate stack.

As is well known in the art, source and drain regions are formed within the substrate adjacent to the gate stack of each MOS transistor. The source and drain regions are generally formed using either an implantation/diffusion process or an etching/deposition process. In the former process, dopants such as boron, aluminum, antimony, phosphorous, or arsenic may be ion-implanted into the substrate to form the source and drain regions. An annealing process that activates the dopants and causes them to diffuse further into the substrate typically follows the ion implantation process. In the latter process, the substrate may first be etched to form recesses at the locations of the source and drain regions. An epitaxial deposition process may then be carried out to fill the recesses with material that is used to fabricate the source and drain regions. In some implementations, the source and drain regions may be fabricated using a silicon alloy such as silicon germanium or silicon carbide. In some implementations the epitaxially deposited silicon alloy may be doped in situ with dopants such as boron, arsenic, or phosphorous. In further embodiments, the source and drain regions may be formed using one or more alternate semiconductor materials such as germanium or a group III-V material or alloy. And in further embodiments, one or more layers of metal and/or metal alloys may be used to form the source and drain regions.

One or more interlayer dielectrics (ILD) are deposited over the MOS transistors. The ILD layers may be formed using dielectric materials known for their applicability in integrated circuit structures, such as low-k dielectric materials. Examples of dielectric materials that may be used include, but are not limited to, silicon dioxide (SiO₂), carbon doped oxide (CDO), silicon nitride, organic polymers such as perfluorocyclobutane or polytetrafluoroethylene, fluorosilicate glass (FSG), and organosilicates such as silsesquioxane, siloxane, or organosilicate glass. The ILD layers may include pores or air gaps to further reduce their dielectric constant.

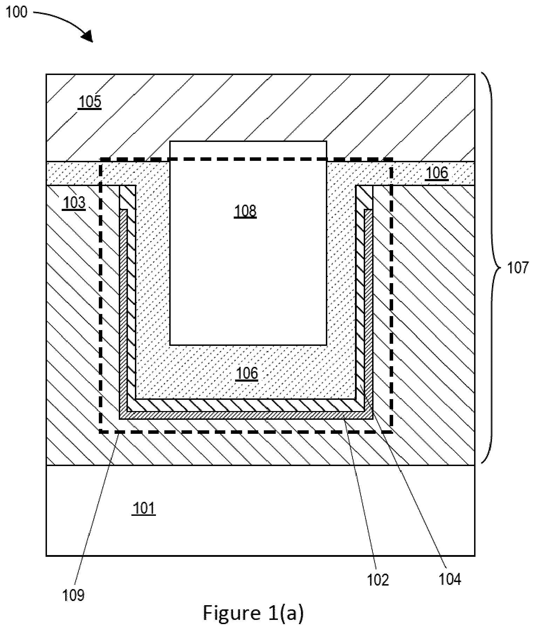

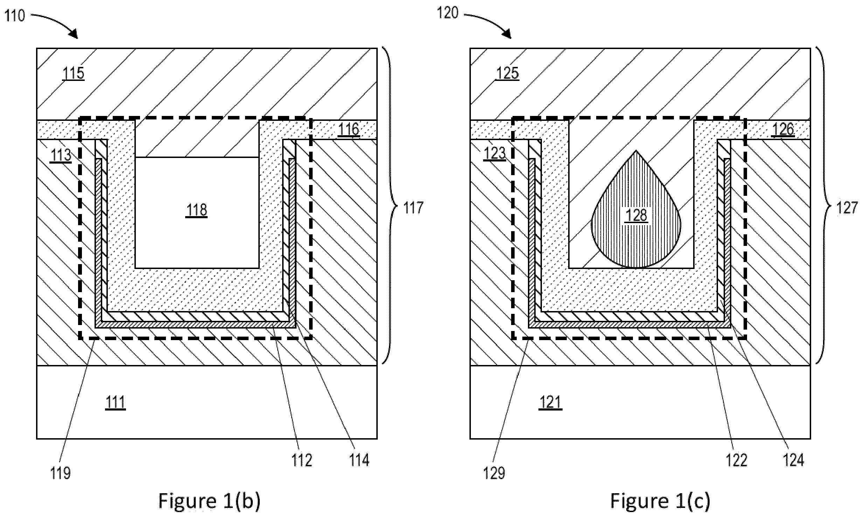

Figures 1(a)-1(c) schematically illustrate diagrams of a semiconductor device including a capacitor and an air gap formed in dielectric layers, in accordance with some embodiments. Figure 1(a) shows a semiconductor device 100 including a capacitor 109 and an air gap 108 formed in dielectric layers. Figure 1(b) shows a semiconductor device 110 including a capacitor 119 and an air gap 118 formed in dielectric layers. Figure 1(c) shows a semiconductor device 120 including a capacitor 129 and an air gap 128 formed in dielectric layers. There may be many other examples of such embodiments, not shown.

In embodiments, as shown in **Figure 1(a)**, the semiconductor device 100 includes the substrate 101, a first ILD layer 103 above the substrate 101, and a second ILD layer 105 above the first ILD layer 103. The capacitor 109 includes a bottom plate 102 above the substrate 101, a capacitor dielectric layer 104 adjacent to and above the bottom plate 102, and a top plate 106 adjacent to and above the capacitor dielectric layer 104. The bottom plate 102, the capacitor dielectric layer 104, and the top plate 106 are within the first ILD layer 103 or the second ILD layer 105. In detail, the bottom plate 102 and the capacitor dielectric layer 104 are within the first ILD layer 103, while the top plate 106 is partially within the first ILD layer 103, and partially at a boundary between the first ILD layer 103 and the second ILD layer 105. The air gap 108 is next to the top plate 106 and below a top surface of the second ILD layer 105, surrounded by the top plate 106 and the second ILD layer 105. The layers shown in Figure 1(a), e.g., the first ILD layer 103, the second ILD layer 105 are a part of a BEOL 107 above the substrate 101, and are shown only for examples, and there may be many other layers not shown, e.g., an etching stop layer, a passivation layer, or a liner.

In embodiments, the bottom plate 102, the capacitor dielectric layer 104, and the top plate 106 may be of various shapes. For example, the bottom plate 102, the capacitor dielectric layer 104, and the top plate 106 each includes a U-shaped portion, and adjacent to each other. Furthermore, the U-shaped portion of the top plate 106 forms a void space that is occupied by the air gap 108. The air gap 108 may be of various shapes. For example, as shown, the air gap 108 may be of a rectangular shape. In other embodiments, the air gap 108 may be of a square shape, a rectangular shape, a circular shape, an elliptical shape, a polygon comprising three or more sides, or a teardrop shape. In embodiments, the air gap 108 may have a thickness between the top plate 106 and the second ILD layer 105 in a range of about 0.5 nanometers (nm) to about 20 nm.

In embodiments, the substrate 101 may include a material selected from the group consisting of a silicon substrate, a glass substrate, a metal substrate, and a plastic substrate. The first ILD layer 103 or the second ILD layer 105 may include a material selected from the group consisting of silicon dioxide (SiO2), carbon doped oxide (CDO), silicon nitride, perfluorocyclobutane, polytetrafluoroethylene, fluorosilicate glass (FSG), organic polymer, silsesquioxane, siloxane, and organosilicate glass. The bottom plate 102 or the top plate 106 may include a material selected from the group consisting of titanium (Ti), molybdenum (Mo), gold (Au), platinum (Pt), aluminum (Al), nickel (Ni), copper (Cu), chromium (Cr), hafnium (Hf), indium (In), and an alloy of Ti, Mo, Au, Pt, Al, Ni, Cu, Cr, TiAIN, HfAIN, or InAlO. Furthermore, the capacitor dielectric layer 104 may include one or more high-k dielectric materials selected from the group consisting of hafnium silicate, zirconium silicate, hafnium dioxide, hafnium zirconate, zirconium dioxide, aluminum oxide, titanium oxide, silicon nitride, carbon doped silicon nitride, silicon carbide, and nitride hafnium silicate.

In embodiments, as shown in **Figure 1(b)****,** the semiconductor device 110 includes the substrate 111, a first ILD layer 113 above the substrate 111, and a second ILD layer 115 above the first ILD layer 113. The first ILD layer 113 and the second ILD layer 115 are a part of a BEOL 117 above the substrate 111. The capacitor 119 includes a bottom plate 112 above the substrate 111, a capacitor dielectric layer 114 adjacent to and above the bottom plate 112, and a top plate 116 adjacent to and above the capacitor dielectric layer 114. The bottom plate 112, the capacitor dielectric layer 114, and the top plate 116 are within the first ILD layer 113 or the second ILD layer 115. For example, the bottom plate 112 and the capacitor dielectric layer 114 are within the first ILD layer 113, the top plate 116 is partially within the first ILD layer 113, and partially at a boundary between the first ILD layer 113 and the second ILD layer 115. The air gap 118 is next to the top plate 116 and below a top surface of the second ILD layer 115, surrounded by the top plate 116 and the second ILD layer 115. Furthermore, the bottom plate 112, the capacitor dielectric layer 114, and the top plate 116 each includes a U-shaped portion, and adjacent to each other. In addition, the U-shaped portion of the top plate 116 forms a void space that is partially occupied by the air gap 118. The air gap 118 may be of a rectangular shape, and is below a top surface of the first ILD layer 113, only partially occupying the void space formed by the U-shaped portion of the top plate 116. In some other embodiments, the bottom plate 112, the capacitor dielectric layer 114, and the top plate 116 may be all within the first ILD layer 113. Additionally and alternatively, the first ILD layer 113 and the second ILD layer 115 may be of a same material and considered as a same layer.

In embodiments, as shown in **Figure 1(c)****,** the semiconductor device 120 includes the substrate 121, a first ILD layer 123 above the substrate 121, and a second ILD layer 125 above the first ILD layer 123. The first ILD layer 123 and the second ILD layer 125 are a part of a BEOL 127 above the substrate 121. The capacitor 129 includes a bottom plate 122 above the substrate 121, a capacitor dielectric layer 124 adjacent to and above the bottom plate 122, and a top plate 126 adjacent to and above the capacitor dielectric layer 124. The bottom plate 122, the capacitor dielectric layer 124, and the top plate 126 are within the first ILD layer 123 or the second ILD layer 125. For example, the bottom plate 122 and the capacitor dielectric layer 124 are within the first ILD layer 123, the top plate 126 is partially within the first ILD layer 123, and partially at a boundary between the first ILD layer 123 and the second ILD layer 125. The air gap 128 is next to the top plate 126 and below a top surface of the second ILD layer 125, surrounded by the top plate 126 and the second ILD layer 125. Furthermore, the bottom plate 122, the capacitor dielectric layer 124, and the top plate 126 each includes a U-shaped portion, and adjacent to each other. In addition, the U-shaped portion of the top plate 126 forms a void space that is partially occupied by the air gap 128. The air gap 128 may be of a teardrop shape, and is below a top surface of the first ILD layer 123, only partially occupying the void space formed by the U-shaped portion of the top plate 126.

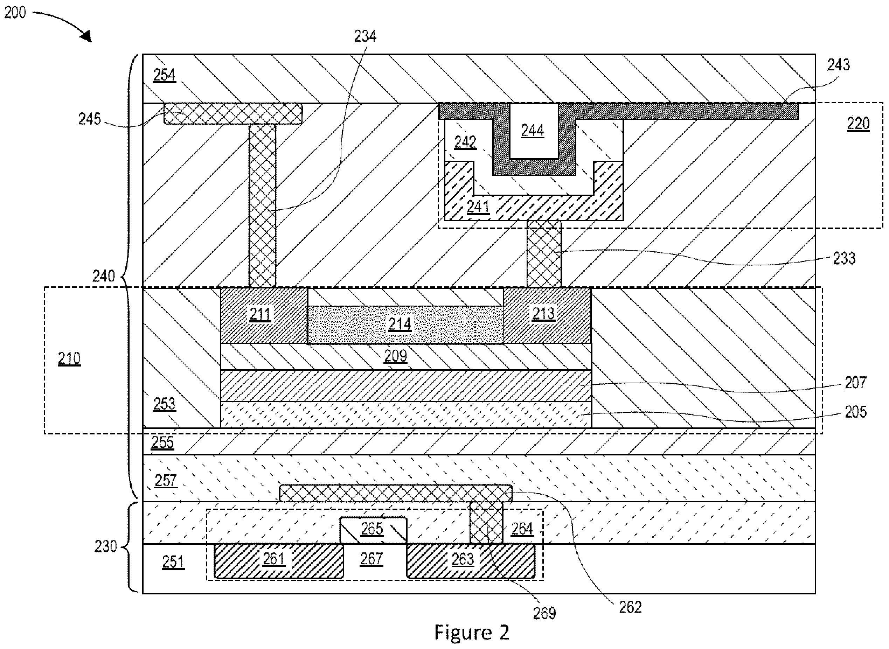

**Figure 2** schematically illustrates a diagram of a memory cell 200 including an air gap 244 next to a capacitor 220 coupled to a TFT 210 in BEOL 240, in accordance with some embodiments. In embodiments, the air gap 244 and the capacitor 220 may be an example of the air gap 108 and the capacitor 109 shown in Figure 1(a), the air gap 118 and the capacitor 119 shown in Figure 1(b), and the air gap 128 and the capacitor 129 shown in Figure 1(c). The TFT 210 is shown as an example only. In some other embodiments, the capacitor 220 may be coupled with a front end transistor within a substrate to form a memory cell, not shown.

In embodiments, the BEOL 240 may include an interconnect structure with multiple layers, e.g., an ILD layer 253, an ILD layer 254, and an ILD layer 257, above a substrate 251. The BEOL 240 includes the TFT 210 coupled to the capacitor 220 to form a memory cell. The capacitor 220 includes a bottom plate 241 and a top plate 243 separated by a capacitor dielectric layer 242. The TFT 210 includes a source electrode 211, a drain electrode 213, a gate electrode 205 above the substrate 251, a channel layer 209 including a channel material, separated from the gate electrode 205 by a gate dielectric layer 207, and a capping layer 214 above the channel layer 209. The drain electrode 213 is coupled to the bottom plate 241 of the capacitor 220 by a short via 233. The source electrode 211 is coupled to a metal electrode 245 by a short via 234. The air gap 244 is next to the top plate 243 of the capacitor 220, and surrounded by the top plate 243 and the ILD layer 254. The short via 233 and the short via 234 may connect two conductors within a same ILD layer. The top plate 243 of the capacitor 220 may be or coupled to a metal electrode located in a first metal layer, while the gate electrode 205 of the transistor 210 is coupled to a metal electrode located in a second metal layer, and the ILD layer 253 is between the first metal layer and the second metal layer. In addition to the TFT 210 within the ILD layer 253, the BEOL 240 may further include the ILD layer 257 separated from the ILD layer 253 by a separation layer 255.

In embodiments, the gate electrode 205 may be coupled to a word line of a memory array, the top plate 243 of the capacitor 220 may be coupled to a bit line of the memory array, and the source electrode 211 may be coupled to a source line of the memory array.

In embodiments, the channel layer 209 includes a material selected from the group consisting of CuS₂, CuSe₂, WSe₂, indium doped zinc oxide (IZO), zinc tin oxide (ZTO), amorphous silicon (a-Si), amorphous germanium (a-Ge), low-temperature poly crystalline silicon (LTPS), transition metal dichalcogenide (TMD), yttrium-doped zinc oxide (YZO), polysilicon, poly germanium doped with boron, poly germanium doped with aluminum, poly germanium doped with phosphorous, poly germanium doped with arsenic, indium oxide, tin oxide, zinc oxide, gallium oxide, indium gallium zinc oxide (IGZO), copper oxide, nickel oxide, cobalt oxide, indium tin oxide, tungsten disulphide, molybdenum disulphide, molybdenum selenide, black phosphorus, indium antimonide, graphene, graphyne, borophene, germanene, silicene, Si₂BN, stanene, phosphorene, molybdenite, poly- III-V like InAs, InGaAs, InP, amorphous InGaZnO (a-IGZO), crystal-like InGaZnO (c-IGZO), GaZnON, ZnON, or C-Axis Aligned Crystal (CAAC), molybdenum and sulfur, and a group-VI transition metal dichalcogenide.

In embodiments, the BEOL 240 may be formed on the FEOL 230. The FEOL 230 may include the substrate 251. In addition, the FEOL 230 may include other devices, e.g., a transistor 264. In embodiments, the transistor 264 may be a FEOL transistor, including a source 261, a drain 263, and a gate 265, with a channel 267 between the source 261 and the drain 263 under the gate 265. Furthermore, the transistor 264 may be coupled to interconnects, e.g., the conductor 262 located in the ILD layer 257, through a via 269.

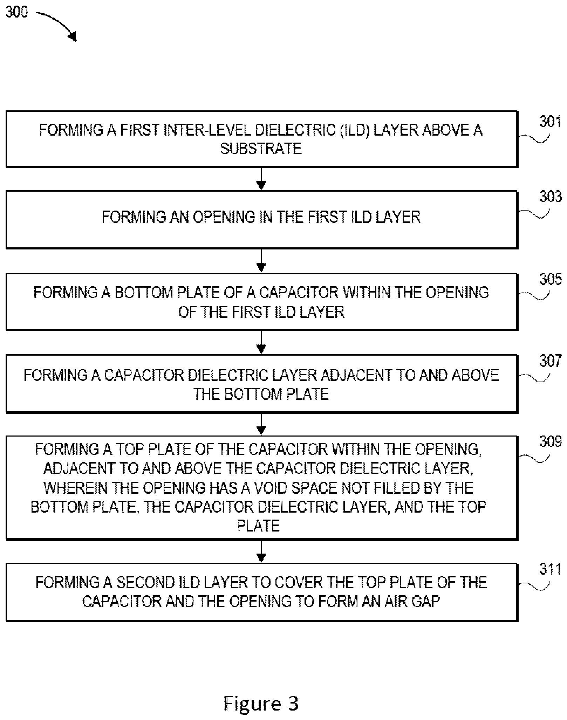

**Figure 3** illustrates a process 300 for forming a semiconductor device including a capacitor and an air gap in dielectric layers, in accordance with some embodiments. In embodiments, the process 300 may be applied to form the semiconductor device 100 including the capacitor 109 and the air gap 108, the semiconductor device 110 including the capacitor 119 and the air gap 118, the semiconductor device 120 including the capacitor 129 and the air gap 128, as shown in Figures 1(a)-1(c), or the semiconductor device 200 including the capacitor 220 and the air gap 244 as shown in Figure 2.

At block 301, the process 300 may include forming a first ILD layer above a substrate. For example, the process 300 may include forming the first ILD layer 103 above the substrate 101, as shown in Figures 1(a).

At block 303, the process 300 may include forming an opening in the first ILD layer. For example, the process 300 may include forming an opening in the first ILD layer 103, where the opening includes a space that contains the capacitor 109 and the air gap 108.

At block 305, the process 300 may include forming a bottom plate of a capacitor within the opening of the first ILD layer. For example, the process 300 may include forming the bottom plate 102 of the capacitor 109 within the opening of the first ILD layer 103. In detail, the bottom plate 102 may be formed by depositing conductive materials at the bottom or sidewall of the opening to form the bottom plate 102.

At block 307, the process 300 may include forming a capacitor dielectric layer adjacent to and above the bottom plate. For example, the process 300 may include forming the capacitor dielectric layer 104 adjacent to and above the bottom plate 102, as shown in Figure 1(a).

At block 309, the process 300 may include forming a top plate of the capacitor within the opening, adjacent to and above the capacitor dielectric layer, where the opening has a void space not filled by the bottom plate, the capacitor dielectric layer, and the top plate. For example, the process 300 may include forming the top plate 106 of the capacitor 109 adjacent to and above the capacitor dielectric layer 104, as shown in Figure 1(a). In embodiments, the top plate 106 may include a U-shaped portion with a void space.

At block 311, the process 300 may include forming a second ILD layer to cover the top plate of the capacitor and the opening to form an air gap, where the air gap is formed within the void space, and surrounded by the second ILD layer and the top plate. For example, the process 300 may include the second ILD layer 105 to cover the top plate 106 of the capacitor 109 and the opening to form the air gap 108, where the air gap is formed within the void space, and surrounded by the second ILD layer 105 and the top plate 106, as shown in Figure 1(a).

In addition, the process 300 may include additional operations to form other layers, e.g., ILD layers, encapsulation layers, insulation layers, not shown.

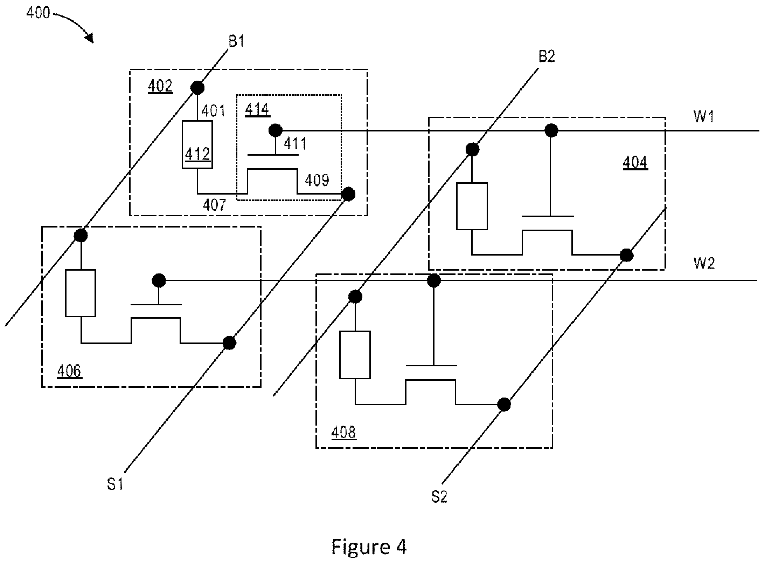

**Figure 4** schematically illustrates a memory array 400 with multiple memory cells (e.g., a memory cell 402, a memory cell 404, a memory cell 406, and a memory cell 408), where a transistor, e.g., a transistor 414, may be a selector of a memory cell, e.g., the memory cell 402, in accordance with various embodiments. In embodiments, the memory cell 402, or other memory cells may be an example of the memory cell 200, as shown in Figure 2, which includes a capacitor and an air gap. The transistor 414 may be a TFT, similar to the TFT 210 as shown in Figure 2. In some other embodiments, the transistor 414 may be a front end transistor having a channel within a substrate.

In embodiments, the multiple memory cells may be arranged in a number of rows and columns coupled by bitlines, e.g., bitline B1 and bitline B2, wordlines, e.g., wordline W1 and wordline W2, and source lines, e.g., source line S1 and source line S2. The memory cell 402 may be coupled in series with the other memory cells of the same row, and may be coupled in parallel with the memory cells of the other rows. The memory array 400 may include any suitable number of one or more memory cells.

In embodiments, multiple memory cells, such as the memory cell 402, the memory cell 404, the memory cell 406, and the memory cell 408, may have a similar configuration. For example, the memory cell 402 may include the transistor 414 coupled to a storage cell 412 that may be a capacitor, which may be called a 1T1C configuration. The memory cell 402 may be controlled through multiple electrical connections to read from the memory cell, write to the memory cell, and/or perform other memory operations.

The transistor 414 may be a selector for the memory cell 402. A wordline W1 of the memory array 400 may be coupled to a gate electrode 411 of the transistor 414. When the wordline W1 is active, the transistor 414 may select the storage cell 412. A bitline B1 of the memory array 400 may be coupled to an electrode 401 of the storage cell 412, while another electrode 407 of the storage cell 412 may be shared with the transistor 414. In addition, a source line S1 of the memory array 400 may be coupled to another electrode, e.g., an electrode 409 of the transistor 414. The shared electrode 407 may be a drain electrode of the transistor 414, while the electrode 409 may be a source electrode of the transistor 414. A drain electrode and a source electrode may be used interchangeably herein. Additionally, a source line and a bit line may be used interchangeably herein.

In some embodiments, for the memory array 400, e.g., an eDRAM memory array, multiple memory cells may have source lines or bitlines coupled together and have a constant voltage. In some embodiments, a common connection may be shared among all the rows and all the columns of the memory array 400. When such sharing occurs, the bitline and source line may not be interchangeable.

In various embodiments, the memory cells and the transistors, e.g., the memory cell 402 and the transistor 414, included in the memory array 400 may be formed in BEOL, as shown in Figure 2. For example, the transistor 414 may be illustrated as the vertical TFT 210 shown in Figure 2 at the BEOL, and the storage cell 412 may be the capacitor 220 shown in Figure 2. Furthermore, there is an air gap 244 next to a top plate 243 of the capacitor 220 as shown in Figure 2, e.g., above the electrode 401. In addition, the memory array 400 may be formed in higher metal layers, e.g., metal layer 3 and/or metal layer 4, of the integrated circuit above the active substrate region, and may not occupy the active substrate area that is occupied by conventional transistors or memory devices.

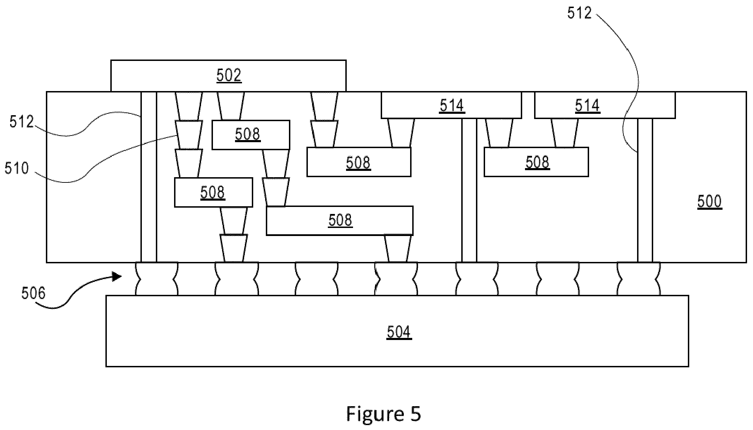

**Figure 5** illustrates an interposer 500 that includes one or more embodiments of the disclosure. The interposer 500 is an intervening substrate used to bridge a first substrate 502 to a second substrate 504. The first substrate 502 may be, for instance, a substrate support for a memory cell, e.g., the memory cell 200, as shown in Figure 2, which includes the capacitor 220 and the air gap 244. The second substrate 504 may be, for instance, a memory module, a computer motherboard, or another integrated circuit die. For example, the second substrate 504 may be a memory module including the memory array 400 as shown in Figure 4. Generally, the purpose of an interposer 500 is to spread a connection to a wider pitch or to reroute a connection to a different connection. For example, an interposer 500 may couple an integrated circuit die to a ball grid array (BGA) 506 that can subsequently be coupled to the second substrate 504. In some embodiments, the first and second substrates 502/504 are attached to opposing sides of the interposer 500. In other embodiments, the first and second substrates 502/504 are attached to the same side of the interposer 500. And in further embodiments, three or more substrates are interconnected by way of the interposer 500.

The interposer 500 may be formed of an epoxy resin, a fiberglass-reinforced epoxy resin, a ceramic material, or a polymer material such as polyimide. In further implementations, the interposer 500 may be formed of alternate rigid or flexible materials that may include the same materials described above for use in a semiconductor substrate, such as silicon, germanium, and other group III-V and group IV materials.

The interposer 500 may include metal interconnects 508 and vias 510, including but not limited to through-silicon vias (TSVs) 512. The interposer 500 may further include embedded devices 514, including both passive and active devices. Such devices include, but are not limited to, capacitors, decoupling capacitors, resistors, inductors, fuses, diodes, transformers, sensors, and electrostatic discharge (ESD) devices. More complex devices such as radiofrequency (RF) devices, power amplifiers, power management devices, antennas, arrays, sensors, and MEMS devices may also be formed on the interposer 500.

In accordance with embodiments of the disclosure, apparatuses or processes disclosed herein may be used in the fabrication of interposer 500.

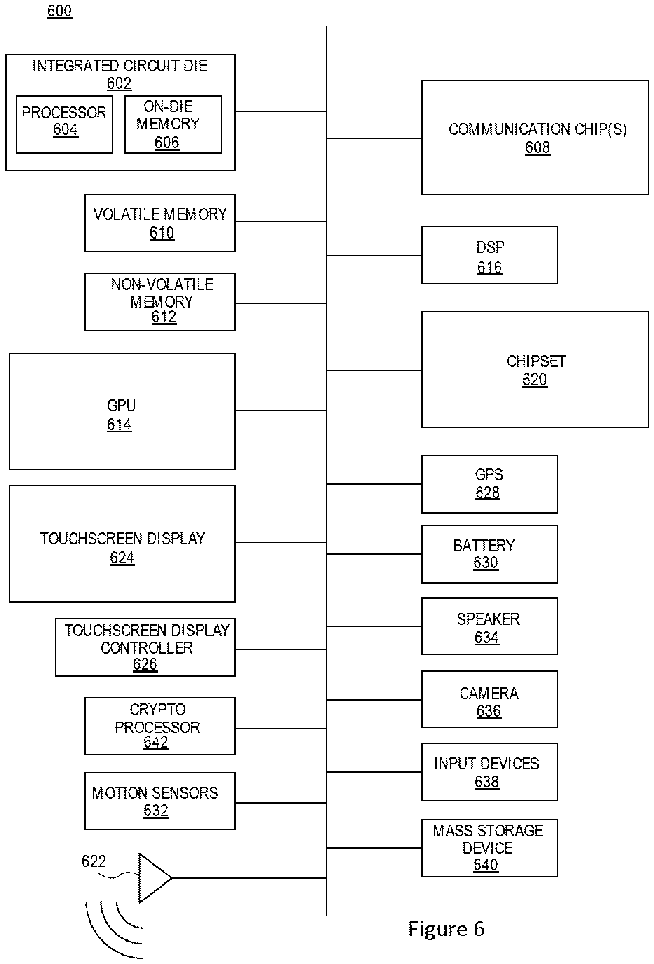

**Figure 6** illustrates a computing device 600 in accordance with one embodiment of the disclosure. The computing device 600 may include a number of components. In one embodiment, these components are attached to one or more motherboards. In an alternate embodiment, some or all of these components are fabricated onto a single system-on-a-chip (SoC) die, such as a SoC used for mobile devices. The components in the computing device 600 include, but are not limited to, an integrated circuit die 602 and at least one communications logic unit 608. In some implementations the communications logic unit 608 is fabricated within the integrated circuit die 602 while in other implementations the communications logic unit 608 is fabricated in a separate integrated circuit chip that may be bonded to a substrate or motherboard that is shared with or electronically coupled to the integrated circuit die 602. The integrated circuit die 602 may include a processor 604 as well as on-die memory 606, often used as cache memory, which can be provided by technologies such as embedded DRAM (eDRAM), or SRAM. For example, the on-die memory 606 may include a memory cell, e.g., the memory cell 200, as shown in Figure 2, which includes the capacitor 220 and the air gap 244.

In embodiments, the computing device 600 may include a display or a touchscreen display 624, and a touchscreen display controller 626. A display or the touchscreen display 624 may include a FPD, an AMOLED display, a TFT LCD, a micro light-emitting diode (µLED) display, or others.

Computing device 600 may include other components that may or may not be physically and electrically coupled to the motherboard or fabricated within a SoC die. These other components include, but are not limited to, volatile memory 610 (e.g., dynamic random access memory (DRAM), non-volatile memory 612 (e.g., ROM or flash memory), a graphics processing unit 614 (GPU), a digital signal processor (DSP) 616, a crypto processor 642 (e.g., a specialized processor that executes cryptographic algorithms within hardware), a chipset 620, at least one antenna 622 (in some implementations two or more antenna may be used), a battery 630 or other power source, a power amplifier (not shown), a voltage regulator (not shown), a global positioning system (GPS) device 628, a compass, a motion coprocessor or sensors 632 (that may include an accelerometer, a gyroscope, and a compass), a microphone (not shown), a speaker 634, a camera 636, user input devices 638 (such as a keyboard, mouse, stylus, and touchpad), and a mass storage device 640 (such as hard disk drive, compact disk (CD), digital versatile disk (DVD), and so forth). The computing device 600 may incorporate further transmission, telecommunication, or radio functionality not already described herein. In some implementations, the computing device 600 includes a radio that is used to communicate over a distance by modulating and radiating electromagnetic waves in air or space. In further implementations, the computing device 600 includes a transmitter and a receiver (or a transceiver) that is used to communicate over a distance by modulating and radiating electromagnetic waves in air or space.

The communications logic unit 608 enables wireless communications for the transfer of data to and from the computing device 600. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communications logic unit 608 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Infrared (IR), Near Field Communication (NFC), Bluetooth, derivatives thereof, as well as any other wireless protocols that are designated as 3G, 4G, 5G, and beyond. The computing device 600 may include a plurality of communications logic units 608. For instance, a first communications logic unit 608 may be dedicated to shorter range wireless communications such as Wi-Fi, NFC, and Bluetooth and a second communications logic unit 608 may be dedicated to longer range wireless communications such as GPS, EDGE, GPRS, CDMA, WiMAX, LTE, Ev-DO, and others.

The processor 604 of the computing device 600 includes one or more devices, such as transistors. The term "processor" may refer to any device or portion of a device that processes electronic data from registers and/or memory to transform that electronic data into other electronic data that may be stored in registers and/or memory. The communications logic unit 608 may also include one or more devices, such as transistors.

In further embodiments, another component housed within the computing device 600 may contain one or more devices, such as DRAM, that are formed in accordance with implementations of the current disclosure, e.g., the memory cell 200, as shown in Figure 2, which includes the capacitor 220 and the air gap 244; the semiconductor device 100 including the capacitor 109 and the air gap 108, the semiconductor device 110 including the capacitor 119 and the air gap 118, the semiconductor device 120 including the capacitor 129 and the air gap 128, as shown in Figures 1(a)-1(c); or a semiconductor device formed following the process 300.

In various embodiments, the computing device 600 may be a laptop computer, a netbook computer, a notebook computer, an ultrabook computer, a smartphone, a dumbphone, a tablet, a tablet/laptop hybrid, a personal digital assistant (PDA), an ultra mobile PC, a mobile phone, a desktop computer, a server, a printer, a scanner, a monitor, a set-top box, an entertainment control unit, a digital camera, a portable music player, or a digital video recorder. In further implementations, the computing device 600 may be any other electronic device that processes data.

**Some non-limiting Examples are provided below.**
Example 1 may include a semiconductor device, comprising: a substrate; a first inter-level dielectric (ILD) layer above the substrate; a second ILD layer above the first ILD layer; a capacitor, wherein the capacitor includes a bottom plate above the substrate, a capacitor dielectric layer adjacent to and above the bottom plate, and a top plate adjacent to and above the capacitor dielectric layer, and wherein the bottom plate, the capacitor dielectric layer, and the top plate are within the first ILD layer or the second ILD layer; and an air gap next to the top plate and below a top surface of the second ILD layer.
Example 2 may include the semiconductor device of example 1 and/or some other examples herein, wherein the bottom plate, the capacitor dielectric layer, and the top plate are within the first ILD layer, and wherein the air gap is below a top surface of the first ILD layer.
Example 3 may include the semiconductor device of examples 1-2 and/or some other examples herein, wherein the capacitor dielectric layer of the capacitor includes a U-shaped portion.
Example 4 may include the semiconductor device of examples 1-2 and/or some other examples herein, wherein the top plate of the capacitor includes a U-shaped portion, and the air gap fills at least a part of a space formed by the U-shaped portion of the top plate.
Example 5 may include the semiconductor device of examples 1-2 and/or some other examples herein, wherein the air gap is of a square shape, a rectangular shape, a circular shape, an elliptical shape, a polygon comprising three or more sides, or a teardrop shape.
Example 6 may include the semiconductor device of examples 1-2 and/or some other examples herein, wherein the substrate includes a material selected from the group consisting of a silicon substrate, a glass substrate, a metal substrate, and a plastic substrate.
Example 7 may include the semiconductor device of examples 1-2 and/or some other examples herein, wherein the first ILD layer or the second ILD layer includes a material selected from the group consisting of silicon dioxide (SiO2), carbon doped oxide (CDO), silicon nitride, perfluorocyclobutane, polytetrafluoroethylene, fluorosilicate glass (FSG), organic polymer, silsesquioxane, siloxane, and organosilicate glass.
Example 8 may include the semiconductor device of examples 1-2 and/or some other examples herein, wherein the bottom plate or the top plate includes a material selected from the group consisting of titanium (Ti), molybdenum (Mo), gold (Au), platinum (Pt), aluminum (Al), nickel (Ni), copper (Cu), chromium (Cr), hafnium (Hf), indium (In), and an alloy of Ti, Mo, Au, Pt, Al, Ni, Cu, Cr, TiAlN, HfAlN, or InAlO.
Example 9 may include the semiconductor device of examples 1-2 and/or some other examples herein, wherein the capacitor dielectric layer includes a high-k dielectric material selected from the group consisting of hafnium silicate, zirconium silicate, hafnium dioxide, zirconium dioxide, aluminum oxide, and nitride hafnium silicate.
Example 10 may include the semiconductor device of examples 1-2 and/or some other examples herein, further comprising: a transistor above the substrate, wherein the transistor includes a gate electrode above the substrate, a channel layer including a channel material, separated from the gate electrode by a gate dielectric layer, and a source electrode and a drain electrode above the channel layer; and wherein the drain electrode is coupled to the bottom plate of the capacitor.
Example 11 may include the semiconductor device of example 10 and/or some other examples herein, wherein the top plate of the capacitor is coupled to a first metal electrode located in a first metal layer, the gate electrode of the transistor is coupled to a second metal electrode located in a second metal layer, and the first ILD layer is between the first metal layer and the second metal layer.
Example 12 may include the semiconductor device of example 10 and/or some other examples herein, wherein the bottom plate of the capacitor is coupled to the drain electrode by a short via within the first ILD layer.
Example 13 may include the semiconductor device of example 10 and/or some other examples herein, wherein the gate electrode is coupled to a word line of a memory array, the top plate of the capacitor is coupled to a bit line of the memory array, and the source electrode is coupled to a source line of the memory array.
Example 14 may include the semiconductor device of example 10 and/or some other examples herein, wherein the transistor and the capacitor are within an interconnect structure that is above the substrate.
Example 15 may include the semiconductor device of example 10 and/or some other examples herein, wherein the channel layer includes a material selected from the group consisting of CuS₂, CuSe₂, WSe₂, indium doped zinc oxide (IZO), zinc tin oxide (ZTO), amorphous silicon (a-Si), amorphous germanium (a-Ge), low-temperature poly crystalline silicon (LTPS), transition metal dichalcogenide (TMD), yttrium-doped zinc oxide (YZO), polysilicon, poly germanium doped with boron, poly germanium doped with aluminum, poly germanium doped with phosphorous, poly germanium doped with arsenic, indium oxide, tin oxide, zinc oxide, gallium oxide, indium gallium zinc oxide (IGZO), copper oxide, nickel oxide, cobalt oxide, indium tin oxide, tungsten disulphide, molybdenum disulphide, molybdenum selenide, black phosphorus, indium antimonide, graphene, graphyne, borophene, germanene, silicene, Si₂BN, stanene, phosphorene, molybdenite, poly- III-V like InAs, InGaAs, InP, amorphous InGaZnO (a-IGZO), crystal-like InGaZnO (c-IGZO), GaZnON, ZnON, or C-Axis Aligned Crystal (CAAC), molybdenum and sulfur, and a group-VI transition metal dichalcogenide.
Example 16 may include a method for forming a semiconductor device, the method comprising: forming a first inter-level dielectric (ILD) layer above a substrate; forming an opening in the first ILD layer; forming a bottom plate of a capacitor within the opening of the first ILD layer; forming a capacitor dielectric layer adjacent to and above the bottom plate; forming a top plate of the capacitor within the opening, adjacent to and above the capacitor dielectric layer, wherein the opening has a void space not filled by the bottom plate, the capacitor dielectric layer, and the top plate; forming a second ILD layer to cover the top plate of the capacitor and the opening to form an air gap, wherein the air gap is formed within the void space, and surrounded by the second ILD layer and the top plate.
Example 17 may include the method of example 16 and/or some other examples herein, wherein the bottom plate, the capacitor dielectric layer, and the top plate are within the first ILD layer, and wherein the air gap is below a top surface of the first ILD layer.
Example 18 may include the method of examples 16-17 and/or some other examples herein, wherein the capacitor dielectric layer of the capacitor includes a U-shaped portion.
Example 19 may include the method of examples 16-17 and/or some other examples herein, wherein the top plate of the capacitor includes a U-shaped portion, and the air gap fills at least a part of a space formed by the U-shaped portion.
Example 20 may include the method of examples 16-17 and/or some other examples herein, wherein the air gap is of a square shape, a rectangular shape, a circular shape, an elliptical shape, a polygon comprising three or more sides, or a teardrop shape.
Example 21 may include a computing device, comprising: a circuit board; and a memory device coupled to the circuit board and including a memory array, wherein the memory array includes a plurality of memory cells, a memory cell of the plurality of memory cells includes a transistor, a capacitor, and an air gap next to a top plate of the capacitor; wherein the transistor includes a gate electrode above a substrate; a channel layer including a channel material, separated from the gate electrode by a gate dielectric layer; and a source electrode and a drain electrode above the channel layer; wherein the capacitor includes a bottom plate above the substrate, a capacitor dielectric layer adjacent to and above the bottom plate, and the top plate adjacent to and above the capacitor dielectric layer; and wherein the bottom plate, the capacitor dielectric layer, and the top plate are within a first ILD layer or a second ILD layer above the first ILD layer; wherein the air gap is next to the top plate and below a top surface of the second ILD layer; and wherein the drain electrode of the transistor is coupled to the bottom plate of the capacitor, the top plate of the capacitor is coupled to a source line of the memory array, and the gate electrode of the transistor is coupled to a word line of the memory array.
Example 22 may include the computing device of example 21 and/or some other examples herein, wherein the air gap has a thickness between the top plate of the capacitor and the second ILD layer in a range of about 0.5 nanometers (nm) to about 20 nm.
Example 23 may include the computing device of examples 21-22 and/or some other examples herein, wherein the channel layer of the transistor includes a material selected from the group consisting of CuS₂, CuSe₂, WSe₂, indium doped zinc oxide (IZO), zinc tin oxide (ZTO), amorphous silicon (a-Si), amorphous germanium (a-Ge), low-temperature polycrystalline silicon (LTPS), transition metal dichalcogenide (TMD), yttrium-doped zinc oxide (YZO), polysilicon, poly germanium doped with boron, poly germanium doped with aluminum, poly germanium doped with phosphorous, poly germanium doped with arsenic, indium oxide, tin oxide, zinc oxide, gallium oxide, indium gallium zinc oxide (IGZO), copper oxide, nickel oxide, cobalt oxide, indium tin oxide, tungsten disulphide, molybdenum disulphide, molybdenum selenide, black phosphorus, indium antimonide, graphene, graphyne, borophene, germanene, silicene, Si₂BN, stanene, phosphorene, molybdenite, poly- III-V like InAs, InGaAs, InP, amorphous InGaZnO (a-IGZO), crystal-like InGaZnO (c-IGZO), GaZnON, ZnON, or C-Axis Aligned Crystal (CAAC), molybdenum and sulfur, and a group-VI transition metal dichalcogenide.
Example 24 may include the computing device of examples 21-22 and/or some other examples herein, wherein the capacitor dielectric layer of the capacitor includes a first U-shaped portion, the top plate of the capacitor includes a second U-shaped portion, the air gap fills at least a part of a space formed by the second U-shaped portion, and the air gap is of a square shape, a rectangular shape, a circular shape, an elliptical shape, a polygon comprising three or more sides, or a teardrop shape.
Example 25 may include the computing device of examples 21-22 and/or some other examples herein, wherein the computing device is a wearable device or a mobile computing device, the wearable device or the mobile computing device including one or more of an antenna, a touchscreen controller, a display, a battery, a processor, an audio codec, a video codec, a power amplifier, a global positioning system (GPS) device, a compass, a Geiger counter, an accelerometer, a gyroscope, a speaker, or a camera coupled with the memory device.

Various embodiments may include any suitable combination of the above-described embodiments including alternative (or) embodiments of embodiments that are described in conjunctive form (and) above (e.g., the "and" may be "and/or"). Furthermore, some embodiments may include one or more articles of manufacture (e.g., non-transitory computer-readable media) having instructions, stored thereon, that when executed result in actions of any of the above-described embodiments. Moreover, some embodiments may include apparatuses or systems having any suitable means for carrying out the various operations of the above-described embodiments.

The above description of illustrated implementations, including what is described in the Abstract, is not intended to be exhaustive or to limit the embodiments of the present disclosure to the precise forms disclosed. While specific implementations and examples are described herein for illustrative purposes, various equivalent modifications are possible within the scope of the present disclosure, as those skilled in the relevant art will recognize.

These modifications may be made to embodiments of the present disclosure in light of the above detailed description. The terms used in the following claims should not be construed to limit various embodiments of the present disclosure to the specific implementations disclosed in the specification and the claims. Rather, the scope is to be determined entirely by the following claims, which are to be construed in accordance with established doctrines of claim interpretation.

## Claims

1. A semiconductor device, comprising:
a substrate;
a first inter-level dielectric (ILD) layer above the substrate;
a second ILD layer above the first ILD layer;
a capacitor, wherein the capacitor includes a bottom plate above the substrate, a capacitor dielectric layer adjacent to and above the bottom plate, and a top plate adjacent to and above the capacitor dielectric layer, and wherein the bottom plate, the capacitor dielectric layer, and the top plate are within the first ILD layer or the second ILD layer; and
an air gap next to the top plate and below a top surface of the second ILD layer.

2. The semiconductor device of claim 1, wherein the bottom plate, the capacitor dielectric layer, and the top plate are within the first ILD layer, and wherein the air gap is below a top surface of the first ILD layer.

3. The semiconductor device of claim 1 or 2, wherein the capacitor dielectric layer of the capacitor includes a U-shaped portion.

4. The semiconductor device of claim 1, 2 or 3, wherein the top plate of the capacitor includes a U-shaped portion, and the air gap fills at least a part of a space formed by the U-shaped portion of the top plate.

5. The semiconductor device of claim 1, 2, 3 or 4, wherein the air gap is of a square shape, a rectangular shape, a circular shape, an elliptical shape, a polygon comprising three or more sides, or a teardrop shape.

6. The semiconductor device of claim 1, 2, 3, 4 or 5, wherein the substrate includes a material selected from the group consisting of a silicon substrate, a glass substrate, a metal substrate, and a plastic substrate.

7. The semiconductor device of claim 1, 2, 3, 4, 5 or 6, wherein the first ILD layer or the second ILD layer includes a material selected from the group consisting of silicon dioxide (SiO₂), carbon doped oxide (CDO), silicon nitride, perfluorocyclobutane, polytetrafluoroethylene, fluorosilicate glass (FSG), organic polymer, silsesquioxane, siloxane, and organosilicate glass.

8. The semiconductor device of claim 1, 2, 3, 4, 5, 6 or 7, wherein the bottom plate or the top plate includes a material selected from the group consisting of titanium (Ti), molybdenum (Mo), gold (Au), platinum (Pt), aluminum (Al), nickel (Ni), copper (Cu), chromium (Cr), hafnium (Hf), indium (In), and an alloy of Ti, Mo, Au, Pt, Al, Ni, Cu, Cr, TiAIN, HfAIN, or InAlO.

9. The semiconductor device of claim 1, 2, 3, 4, 5, 6, 7 or 8, wherein the capacitor dielectric layer includes a high-k dielectric material selected from the group consisting of hafnium silicate, zirconium silicate, hafnium dioxide, zirconium dioxide, aluminum oxide, and nitride hafnium silicate.

10. The semiconductor device of claim 1, 2, 3, 4, 5, 6, 7, 8 or 9, further comprising:
a transistor above the substrate, wherein the transistor includes a gate electrode above the substrate, a channel layer including a channel material, separated from the gate electrode by a gate dielectric layer, and a source electrode and a drain electrode above the channel layer; and wherein the drain electrode is coupled to the bottom plate of the capacitor.

11. A method for forming a semiconductor device, the method comprising:
forming a first inter-level dielectric (ILD) layer above a substrate;
forming an opening in the first ILD layer;
forming a bottom plate of a capacitor within the opening of the first ILD layer;
forming a capacitor dielectric layer adjacent to and above the bottom plate;
forming a top plate of the capacitor within the opening, adjacent to and above the capacitor dielectric layer, wherein the opening has a void space not filled by the bottom plate, the capacitor dielectric layer, and the top plate;
forming a second ILD layer to cover the top plate of the capacitor and the opening to form an air gap, wherein the air gap is formed within the void space, and surrounded by the second ILD layer and the top plate.

12. The method of claim 11, wherein the bottom plate, the capacitor dielectric layer, and the top plate are within the first ILD layer, and wherein the air gap is below a top surface of the first ILD layer.

13. The method of claim 11 or 12, wherein the capacitor dielectric layer of the capacitor includes a U-shaped portion.

14. The method of claim 11, 12 or 13, wherein the top plate of the capacitor includes a U-shaped portion, and the air gap fills at least a part of a space formed by the U-shaped portion.

15. The method of claim 11, 12, 13 or 14, wherein the air gap is of a square shape, a rectangular shape, a circular shape, an elliptical shape, a polygon comprising three or more sides, or a teardrop shape.
